Europäisches Patentamt

European Patent Office

Office européen des brevets

(19)

(11) Veröffentlichungsnummer: **0 002 503**
B1

(12) # EUROPÄISCHE PATENTSCHRIFT

(45) Veröffentlichungstag der Patentschrift: 28.04.82

(21) Anmeldenummer: 78101598.7

(22) Anmeldetag: 07.12.78

(51) Int. Cl.³: **H 01 L 21/263,**
**H 01 L 21/306,**
**C 23 C 15/00**

(54) Verfahren zum Ätzen von Siliciumdioxid.

(30) Priorität: 19.12.77 US 861796

(43) Veröffentlichungstag der Anmeldung:
27.06.79 Patentblatt 79/13

(45) Bekanntmachung des Hinweises auf die Patenterteilung:
28.04.82 Patentblatt 82/17

(84) Benannte Vertragsstaaten:
DE FR GB

(73) Patentinhaber: International Business Machines
Corporation
Armonk, N.Y. 10504 (US)

(72) Erfinder: Clark, Harold Albert
Road 5, Box 44
Hopewell Junction New York 12533 (US)

(74) Vertreter: Kreidler, Eva-Maria, Dr. rer. nat.
Schönaicher Strasse 220
D-7030 Böblingen (DE)

(56) Entgegenhaltungen:
DE - A - 2 703 659
FR - A - 2 240 526
US - A - 3 867 216
SOLID STATE TECHNOLOGY, vol. 19, no. 5,
May 1976, Port Washington, L. I., N. Y. 11050,
R. L. BERSIN "A survey of plasma-etching
processes" Seiten 31 bis 36
SOLID STATE TECHNOLOGY, vol. 19, no. 9,
September 1976, Port Washington, L.I., N.Y.
11050,
A. JACOB "The versatile technique of rf plasma
etching, Part I-the etch profile" Seiten 70 bis 73

(56) Entgegenhaltungen:
SOLID STATE TECHNOLOGY, vol. 19, no. 10,
October 1976, Port Washington, L.I., N.Y.
11050,
R. KUMAR et al "Characterization of plasma
etching for semiconductor applications" Seiten
54 bis 59

SOLID STATE TECHNOLOGY, vol. 20, no. 6,
June 1977, Port Washington, L.I., N.Y. 11050,
A. JACOB "The versatile technique of rf plasma
etching, Part II-Kinetics of etchant formation"
Seiten 31 bis 36

Courier Press, Leamington Spa, England.

# 0 002 503

## Verfahren zum Ätzen von Siliciumdioxid

Die Erfindung betrifft ein Verfahren zum Ätzen von Siliciumdioxid in einem Gasplasma aus Kohlenstofftetrafluorid und Sauerstoff.

Das Ätzen von Siliciumverbindungen, wie Siliciumdioxid und -nitrid in einem Gasplasma im Zusammenhang mit der Herstellung integrierter Schaltkreise ist bekannt. Gasplasmen, die aus Fluorkohlenwasserstoffen und Mischungen von Fluorkohlenwasserstoffen mit Sauerstoff hergestellt wurden, sind beispielsweise in den US-Patentschriften 3 615 956, 3 795 557 und 3 867 216 und der deutschen Offenlegungsschrift 27 03 659 bekannt. Ein Nachteil dieser Verfahren ist, daß Silicium schneller als Siliciumdioxid geätzt wird. Deshalb ist es beim Ätzen einer Siliciumdioxidschicht auf Silicium schwierig, das Verfahren zu beenden, ehe die Siliciumoberfläche in unerwünschtem Maße angeätzt wird. In diesem Fall ist das Verfahren nicht mehr durchführbar, oder es muß ein Naßätzverfahren zum Ätzen von Siliciumdioxid durchgeführt werden, oder das Plasmaätzen muß kurz vor dem Erreichen der Siliciumoberfläche gestoppt und der Rest der Siliciumdioxidschicht durch Naßätzen abgetragen werden.

Es wurden auch Mischungen von Wasserstoff und Fluorkohlenwasserstoffen eingesetzt, um ein günstiges Ätzratenverhältnis von Siliciumdioxid zu Silicium zu erhalten. Diese Reaktion ist schwierig zu überwachen und kann zu einer Polymerbildung führen, welche den Ätzvorgang unterbricht. Es wurde nunmehr ein Verfahren gefunden, welches das Ätzen von Siliciumdioxidschichten auf einer Siliciumunterlage gestattet. Die Erfindung, wie sie in den Ansprüchen gekennzeichnet ist, löst die Aufgabe, Siliciumdioxid, welches auf einer Siliciumunterlage angeordnet ist, in einem Gasplasma zu ätzen. Die Mischung, die erfindungsgemäß hierzu verwendet wird, enthält mindestens 5, aber nicht über 15 Vol.% Kohlenstofftetrafluorid und den Rest Sauerstoff und weist einen Gesamtdruck von 133,322 Pa auf.

Im folgenden wird die Erfindung in der speziellen Beschreibung und anhand der Ausführungsbeispiele näher erläutert.

Das erfindungsgemäße Verfahren wird in einer Reaktionskammer ausgeführt, in der induktiv oder kapazitiv zugeführte Hochfrequenzenergie verwendet wird, um ein Gasplasma mit dem erforderlichen Druck von 133.322 Pa zu erzeugen. Geeignete Reaktoren, die für einen Druckbereich von etwa 66.66 Pa bis 266.644 Pa konsipiert sind, beispielsweise LFE model PDE 301 oder PDE 501, sind im Handel erhältlich. Geeignete Gase zum selektiven Ätzen von Siliciumdioxid in Gegenwart von Silicium und/oder Siliciumnitrid sind Mischungen, die mehr als 5 aber höchstens 15 Vol.% Kohlenstofftetrafluorid ($CF_4$) und den jeweiligen Rest an Sauerstoff enthalten. Eine Mischung mit einem Gesamtdruck von etwa 133,322 Pa, die nur 5 Vol.% (6,665 Pa Partialdruck) von Kohlenstofftetrafluorid in Sauerstoff enthält, ist nicht geeignet, Silicium oder Siliciumdioxid meßbar zu ätzen. Eine Mischung mit einem Gesamtdruck von etwa 133,322 Pa, die 15 Vol.% (19,995 Pa Partialdruck) Kohlenstofftetrafluorid enthält, ätzt Siliciumdioxid etwa 1,6 mal schneller als Silicium. Bei einem CE-Partialdruck von 26,66 Pa werden Siliciumdioxid und Siliciumnitrid mit etwa gleichen Ätzraten gesätzt. Der Kohlenstofftetrafluoridgehalt der Gasmischung sollte daher über 5 Vol.% liegen, damit Siliciumdioxid geätzt werden kann. Er sollte 15 Vol.% nicht überschreiten, damit ein günstiges Ätzratenverhältnis von Siliciumdioxid zu Silicium aufrechterhalten werden kann. Eine bevorzugte Mischung mit einem optimalen Ätzratenverhältnis zwischen Siliciumdioxid und Silicium oder Siliciumnitrid enthält 10 Vol.% Kohlenstofftetrafluorid und 90 Vol.% Sauerstoff, wodurch ein Ätzratenverhältnis von Oxid zu Silicium von etwa 5:1 und von Oxid zu Nitrid von etwa 3:1 erhalten wird.

Die relativ hohen Prozentgehalte an Sauerstoff in den Gasmischungen bewirken, daß diese nichtbehandelten Photoresist angreifen, Deshalb ist es notwendig, entweder dicke Photoresistschichten oder zusätzliche Maskenschichten aus Materialien zu verwenden, die durch das Plasma nicht angegriffen werden. Weil in dem erfindungsgemäßen Verfahren ein Ätzratenverhältnis von Siliciumdioxid zu Siliciumnitrid von 3:1 erhalten wird, kann Siliciumnitrid als zusätzliche Maskenschicht verwendet werden. Das Verfahren kann in vorteilhafter Weise angewendet werden zum Ätzen von Durchführungsöffnungen durch dielektrische Schichten aus Siliciumnitrid und Siliciumdioxid zur Siliciumunterlage. Das Photoresistmuster wird auf der Nitridschicht gebildet, und das Nitrid wird beispielsweise in einem Gasplasma aus Kohlenstofftetrafluorid oder Kohlenstofftetrafluorid mit einem Gehalt an 8 Vol.% Sauerstoff geätzt. Das Siliciumdioxid wird dann unter Anwendung des erfindungsgemäßen Verfahrens bis auf die Siliciumunterlage abgeätzt. Das Ätzratenverhältnis von 5:1 für Oxid zu Silicium gestattet, das Ätzen an der Siliciumoberfläche zu unterbrechen. Gleichzeitig wird der Photoresist entfernt, so daß ein zusätzlicher Schritt zur Entfernung der Photoresists nicht erforderlich ist.

### Beispiel 1

Siliciumwafer, die mit einer 100 nm dicken Schicht thermischen Siliciumdioxids und einer 150 nm dicken Siliciumnitridschicht auf dem Siliciumdioxid beschichtet sind, werden mit einer etwa 1,0 $\mu$m dicken Schicht eines positiv arbeitenden, mit einem Diazochinon sensibilisierten Phenolformaldehyd-Novolakharzes beschichtet, und in dem Photoresist wird mittels bekannter photolithographischer Verfahren ein Muster erzeugt, um die gewünschten Bereiche der Siliciumnitridschicht zum Ätzen freizulegen. Die Wafer werden in einen Plasmaätzreaktor gegeben, und das Nitrid wird geätzt unter An-

2

0 002 503

wendung einer Mischung von 92 Vol.% $CF_4$ und 8 Vol.% $O_2$ bei einem Druck von 66,66 Pa und einer Leistung von 300 Watt. Das Gasplasma wird dann gewechselt, und eine Mischung von 10 Vol.% $CF_4$ und 90 Vol.% $O_2$ bei einem Gesamtdruck von etwa 133,322 Pa und einer Leistung von 300 Watt wird angewendet. Das Siliciumdioxid wird bis auf die Siliciumunterlage entfernt bei Verwendung von Siliciumnitrid als Ätzmaske. Der Photoresist wird während des Ätzens der Siliciumdioxidschicht bis zur Siliciumunterlage vollständig entfernt.

Beispiel 2

Die Ätzraten in nm/Min. von Silicium, Siliciumdioxid und Siliciumnitrid wurden in einem Plasmaätzreaktor gemessen unter den in der nachfolgenden Tabelle I angegebenen Bedingungen und bei einer Leistung von 300 Watt und einem Gesamtdruck von etwa 133,322 Pa.

TABELLE I

| Partialdruck in Pa | Partialdruck von $O_2$ in Pa | Ätzraten nm/Min. | | |
|---|---|---|---|---|
| | | $SiO_2$ | Si | $Si_3N_4$ |
| 6,665 $CF_4$ | 126,635 | 0 | 0 | — |
| 13,33 $CF_4$ | 119,97 | 10 | 2 | 3 |
| 19,995 $CF_4$ | 113,305 | 16 | 10 | — |
| 26,664 $CF_4$ | 106,64 | 16 | 10 | 14 |
| 39,99 $CF_4$ | 93,31 | — | 20 | — |
| 13,33 $CCl_2F_2$ | 119,97 | 40 | 160 | — |

Aus Tabelle I ist ersichtlich, daß der Partialdruck von $CF_4$ über 6,665 Pa liegen sollte, damit ein Ätzen stattfindet. Bei 19,995 Pa oder darüber hat die Ätzrate von Silicium relativ zu Siliciumdioxid zugenommen, so daß das Ätzratenverhältnis von Oxid zu Silicium auf einen Wert von etwa 1,6 zu 1 absinkt. Bei etwa 13,33 Pa $CF_4$ ist das Ätzratenverhältnis optimal und liegt bei etwa 5:1.

Beispiel 3

In der US-Patentschrift 3 795 557 ist in der Tabelle über die Spalten 5 und 6 das Ätzen von thermischen Oxid mit einer Mischung von $CHF_3$ und 93,7 Vol.% $O_2$ bei einem Druck von etwa 399,966 Pa bei einer Leistung von 300 Watt angegeben. Es sind keine Daten über relative Ätzgeschwindigkeiten angegeben. Um herauszufinden, ob diese Mischung zu den gleichen Ergebnissen führt wie das erfindungsgemäße Verfahren, wurden die Ätsratenverhältnisse von Siliciumdioxid und Silicium in einem Reaktor bei 400 Watt und mit einer Mischung von $CHF_3$ und 93,7 Vol.% Sauerstoff in verschiedenen Durchgängen bei Gesamtdrucken von 66,66 Pa und 399,966 Pa gemessen. Die Ergebnisse sind in Tabelle II aufgetragen.

TABELLE II

| Druck in Pa | Ätzraten nm/Min. | | Verhaltnis $SiO_2/Si$ |
|---|---|---|---|
| | $SiO_2$ | Si | |
| 66,66 | 17,5 | 13.5—14,0 | 1,3:1 |
| 399,966 | 16,5 | 20 | 0,8:1 |

Die Ergebnisse zeigen, daß bei den Druckbedingungen, die in dieser Patentschrift angegeben sind, Silicium etwas schneller als Siliciumdioxid geätzt wird. Bei einem niedrigeren Druck von 66,66 Pa wird das Oxid etwas schneller geätzt, aber ein Ätzratenverhältnis von nur 1,3:1 gestattet nicht, den Ätzvorgang bei Erreichen der Siliciumoberfläche abzubrechen.

Bei dem erfindungsgemäßen Verfahren findet eine Umkehr der Ätzratenverhältnisse zwischen Siliciumdioxid und Silicium statt, so daß Siliciumdioxidschichten relativ zu Silicium mit einer vernünftigen Geschwindigkeit geätzt werden können und der Ätzvorgang bei Erreichen der Siliciumoberfläche abgebrochen werden kann, ehe diese in beträchtlichem Maße angeätzt wird. Dadurch entfällt die Notwendigkeit, Naßätzverfahren anzuwenden oder wasserstoffhaltige Gasmischungen, welche zu einer

**0 002 503**

Polymerbildung führen können, die das Ätzen der Oxidschicht unterbricht. Das erfindungsgemäße Verfahren gestattet das Ätzen von Durchführungsöffnungen durch dielektrische Schichten aus Siliciumnitrid und Siliciumdioxid begleichzeitiger Entfernung der Photoresistschichten.

## Patentansprüche

1. Verfahren zum Ätzen von Siliciumdioxid in einem Gasplasma aus Kohlenstofftetrafluorid und Sauerstoff dadurch gekennzeichnet, daß zum Ätzen ein Plasma aus einer Mischung von über 5, aber nicht über 15 Vol.% Kohlenstofftetrafluorid und dem Rest Sauerstoff mit einem Gesamtdruck von 133,322 Pa angewendet wird.

2. Verfahren nach Anspruch 1, dadurch gekennzeichnet, daß mit dem Plasma aus einer Mischung von über 5, aber nicht über 15 Vol.% Kohlenstofftetrafluorid und dem Rest Sauerstoff mit einem Gesamtdruck von 133,322 Pa eine auf einer Siliciumunterlage angeordnete Siliciumdioxidschicht durch eine Ätzmaske hindurch geätzt wird.

3. Verfahren nach den Ansprüchen 1 und 2, dadurch gekennzeichnet, daß eine Ätzmaske aus Siliciumnitrid verwendet wird.

4. Verfahren nach den Ansprüchen 1 und 2, dadurch gekennzeichnet, daß eine Ätzmaske aus einer Doppelschicht aus einem organischen Photoresist und Siliciumnitrid verwendet wird und der Photoresist gleichzeitig mit dem Siliciumdioxid durch Ätzen entfernt wird.

5. Verfahren nach den Ansprüchen 1 und 2, dadurch gekennzeichnet, daß zum Ätzen eine Mischung aus 10 Vol.% Kohlenstofftetrafluorid und 90 Vol.% Sauerstoff mit einem Gesamtdruck von 133,322 Pa angewendet wird.

## Revendications

1. Procédé pour décaper du dioxyde de silicium dans un plasma de gaz de tétrafluorure de carbon et d'oxygène, caractérisé en ce qu'on utilise pour le décapage un plasma composé d'un mélange de tétrafluorure de carbone et d'oxygène, la proportion de tétrafluorure de carbone étant comprise entre 5 et 15% en volume du mélange avec une pression totale de 133,322 Pa.

2. Procédé selon la revendication 1, caractérisé en ce que, à l'aide du plasma composé du mélange précité, dans les conditions de pression précitées, on décape une couche de dioxyde de silicium déposée sur un substrat de silicium à travers un masque de décapage.

3. Procédé selon l'une quelconque des revendications 1 et 2, caractérisé en ce qu'on utilise un masque de décapage de nitrure de silicium.

4. Procédé selon l'une quelconque des revendications 1 et 2, caractérisé en ce qu'on utilise un masque de décapage comportant une couche double d'un matériau photorésistant organique et de nitrure de silicium et qu'on enlève, par décapage, le matériau photorésistant en même temps que le dioxyde de silicium.

5. Procédé selon l'une quelconque des revendications 1 et 2, caractérisé en ce qu'on utilise, pour le décapage, un mélange de 10% en volume de tétrafluorure de carbone et de 90% en volume d'oxygène avec une pression totale de 133,322 Pa.

## Claims

1. Method of etching silicon dioxide in a gas plasma of carbon tetrafluoride and oxygen, characterized in that a plasma consisting of a mixture of more than 5, but not more than 15 percent by volume of carbon tetrafluoride and the remainder oxygen with a total pressure of 133.322 Pa is used for etching.

2. Method as claimed in claim 1, characterized in that with the plasma consisting of a mixture of more than 5, but not more than 15 percent by volume of carbon tetrafluoride and the remainder oxygen, with a total pressure of 133.322 Pa, a silicon dioxide layer arranged on a silicon substrate is etched through an etching mask.

3. Method as claimed in claims 1 and 2, characterized in that an etching mask of silicon nitride is used.

4. Method as claimed in claims 1 and 2, characterized in that an etching mask of a composite layer of an organic photoresist and silicon nitride is used, and the photoresist is removed by etching simultaneously with the silicon dioxide.

5. Method as claimed in claims 1 and 2, characterized in that a mixture of 10 percent by volume of carbon tetrafluoride and 90 percent by volume of oxygen with a total pressure of 133.322 Pa is used for etching.